# EUROPÄISCHE PATENTANMELDUNG

(11) **EP 1 002 888 A2**
(43) Veröffentlichungstag der Anmeldung: **24.05.2000**
(21) Anmeldenummer: 99122934.5
(22) Anmeldetag: 18.11.1999
(51) Int. Cl.: C23C 16/50, H01J 37/32, B05D 7/24

(54) **Verfahren und Einrichtung zur Behandlung eines Substrates in einem Hochfrequenzplasma**

(30) Priorität: 18.11.1998 DE 19853121
(71) Anmelder: VON ARDENNE ANLAGENTECHNIK GmbH, 01324 Dresden (DE)
(72) Erfinder: Poll, Hans-Ulrich, Prof. Dr., 09127 Chemnitz (DE)
(74) Vertreter: Patentanwälte Lippert, Stachow, Schmidt & Partner

(57) **Zusammenfassung**

Die Erfindung betrifft ein Verfahren und eine Einrichtung zur Behandlung einer Oberfläche eines dünnwandigen Substrates aus einem isolierenden Material in einem Hochfrequenzplasma, bei dem die zu behandelnde Oberfläche als eine Elektrode der Hochfrequenz-Entladung geschaltet wird, wobei auf der Oberfläche eine dünne elektrisch leitfähige Schicht ausgebildet wird und die Energiezufuhr zur leitfähigen Schicht mittels einer Kopplungselektrode erfolgt, welche an der Seite dicht am Substrat angeordnet wird, die sich von der zu beschichtenden Oberfläche aus hinter dem Substrat befindet.

## Beschreibung

Die Erfindung betrifft ein Verfahren und eine Einrichtung zur Behandlung einer Oberfläche eines dünnwandigen Substrates aus einem isolierenden Material in einem Hochfrequenzplasma, bei dem die zu behandelnde Oberfläche als eine Elektrode der Hochfrequenz-Plasmaentladung geschaltet ist. Des weiteren betrifft die Erfindung eine Anwendung der Einrichtung.

Unter einem dünnwandigen Substrat wird hierbei ein Substrat mit einer Wanddicke von im wesentlichen weniger als 5 mm verstanden. Dabei kann das Substrat auch ein unregelmäßig geformtes Kunststoffteil sein, z. B. ein Reflektor für eine Fahrzeugleuchte, eine Glas- oder Keramikplatte, bei dem nur ein Teil als dünnwandig im vorgenannten Sinne zu bezeichnen ist.

Nach dem Stand der Technik sind Verfahren bzw. Einrichtungen bekannt, mit denen isolierende Substrate in einem Plasma behandelt werden können, wobei die vorliegende Erfindung grundsätzlich alle bekannten Plasma-Behandlungsverfahren erfasst, bei denen die Substrate in irgendeiner Weise im Beisein eines Plasmas behandelt werden. Beispielsweise kann es sich bei einer derartigen Behandlung um ein Plasmaätzen oder um eine plasmagestützte Beschichtung handeln wie auch um eine Plasmabehandlung, bei der das Material des Substrates verändert oder beeinflusst wird.

Zur Ausbildung eines Plasmas in einer Plasmakammer oder Vakuumkammer mittels einer Hochfrequenz-Entladung werden die Elektroden von einem Hochfrequenz-Generator innerhalb der Plasmakammer in geeigneter Weise angeordnet, derart dass sich zwischen diesen eine Entladung ausbilden kann. Vielfach werden dazu spezielle Elektroden angeordnet. Von Vorteil ist es, wenn die zu behandelnden Substrate selbst als eine der beiden Elektroden geschaltet werden, da sich dann direkt an den Elektroden besonders energiereiche Plasmaprozesse ausbilden. Die Bearbeitungseffekte beim Plasmaätzen und auch die Beschichtungsraten bei einem Beschichtungsprozess sind dabei relativ hoch. Die elektrische Leistung wird beispielsweise aus einem Hochfrequenz-Generator über einen sogenannten Bias-Kondensator zugeführt, der eine durch die Gasentladung entstehende Gleichspannungskomponente von der das Plasma erzeugenden, hochfrequenten Wechselspannung abtrennt.

Wenn es sich bei den zu behandelnden Substraten um nichtleitende Materialien, z.B. Kunststoffe, handelt, dann ist es grundsätzlich nicht möglich, dieses Material als Elektrode der Hochfrequenz-Entladung einzusetzen. Nach dem Stand der Technik werden deshalb spezielle Elektroden in der Nähe des Substrates angeordnet.

Die EP 0794014 A gibt ein Verfahren und eine Einrichtung zur Hochfrequenz-Plasmapolymerisation an, mit denen auf der Oberfläche von Substraten Polymerschichten abgeschieden werden. Dabei werden die Substrate oder die Substrathalterungen als eine Elektrode der Hochfrequenz-Gasentladung geschaltet. Bei elektrisch isolierenden Substraten wird auf deren Oberfläche vorher eine einheitliche leitende Schicht ausgebildet, die elektrisch mit der Substrathalterung verbunden ist und somit als Elektrode wirkt.

Der Erfindung liegt als Aufgabe zugrunde, ein Verfahren und eine Einrichtung der eingangs beschriebenen Art anzugeben, mit denen bei geringem technischen Aufwand und hoher Verfahrenssicherheit die Oberfläche eines dünnwandigen isolierenden Substrates in einem Hochfrequenzplasma behandelt werden kann. Des weiteren soll eine vorteilhafte Anwendung der Einrichtung angegeben werden.

Die Erfindung löst die Aufgabe für das Verfahren nach Anspruch 1 und für die Einrichtung nach Anspruch 4. Die vorteilhafte Anwendung der Einrichtung ist in Anspruch 8 angegeben.

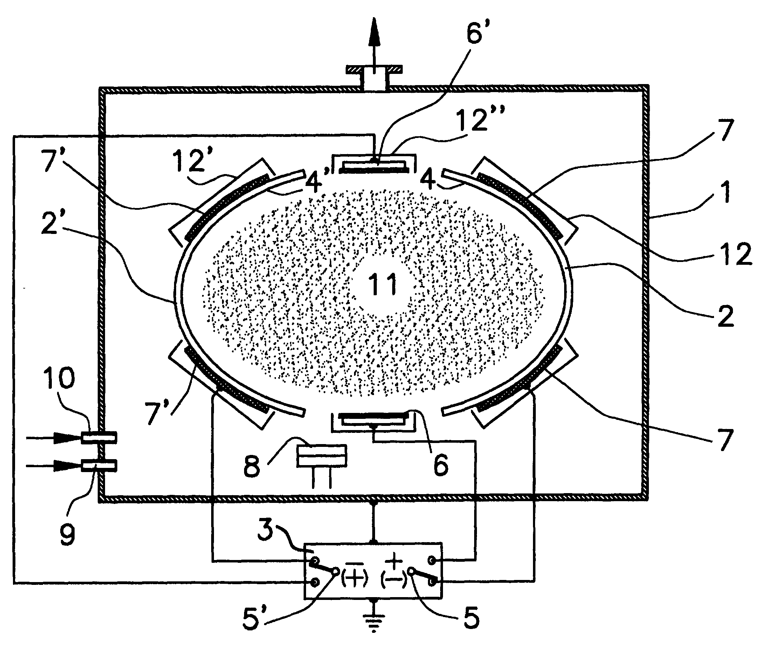

Vorteilhafte Weiterbildungen der Erfindung sind in den jeweiligen Unteransprüchen gekennzeichnet und werden nachstehend zusammen mit der Beschreibung der bevorzugten Ausführung der Erfindung, einschließlich der Zeichnung, näher dargestellt.

Der Kern der Erfindung besteht darin, dass die Wirkung einer kapazitiven Kopplung zwischen dem Hochfrequenz-Generator und dem Plasma in überraschender Weise von der Kopplungselektrode über das Substrat aus isolierendem Material hinweg zu einer dünnen isoliert auf dem Substrat angeordneten leitfähigen Schicht ausgenutzt wird und die leitfähige Schicht als Elektrode der Hochfrequenz-Plasmaentladung genutzt wird.

In bekannter Weise wird die zu behandelnde Oberfläche des Substrates vorher mit einer dünnen leitfähigen Schicht beschichtet. Zur elektrischen Kontaktierung dieser Schicht und Ausbildung einer Elektrode für die Hochfrequenz-Plasmaentladung wird eine Kopplungselektrode von der leitfähigen Schicht aus hinter dem dünnwandigen Substrat angeordnet. Wenn die Kopplungselektrode an Hochfrequenz gelegt wird, entsteht ein Ladungsträgeraustausch zwischen der Kopplungselektrode über den Isolator "Substrat" und gegebenfalls einen noch vorhandenen Luftspalt zur dünnen leitfähigen Schicht und diese wird zur Elektrode der Hochfrequenz-Plasmaentladung. Dabei muss der Abstand zwischen der Kopplungselektrode und der leitfähigen Schicht, z. B. bei einem ungleichmäßig geformten Substrat, nicht über die gesamte Fläche konstant sein. Ein möglicher Spalt sollte jedoch kleiner sein als die Dicke des Dunkelraumes vor der Plasmaelektrode.

Die Spannung zwischen der Kopplungselektrode und der leitfähigen Schicht hängt im wesentlichen von der Entladungsfrequenz, der Plasmastromdichte und den geometrischen Verhältnissen ab. Dabei ist es nicht erforderlich, die Fläche der Kopplungselektrode an die gesamte zu beschichtenden Fläche anzupassen. Es ist aber vorteilhaft, wenn die Fläche der Kopplungselektrode mit der sie an dem Substrat anliegt größer 30% der zu beschichtenden Fläche ist. Bei einer relativ geringen Fläche der Kopplungselektrode nimmt die Kondensatorwirkung und damit die in das Plasma eingespeiste elektrische Leistung ab.

An den seitlichen Bereichen dürfen die Kopplungselektrode und die leitfähigen Schicht nicht zu eng aneinander liegen, damit sich dort keine leitfähige Verbindung ausbildet. Besteht im konkreten Verfahrensablauf die Gefahr, dass sich gelegentlich eine leitfähige Verbindung zwischen der Kopplungselektrode und der dünnen leitfähigen Schicht ausbildet, z. B. bei einer Beschichtung mit einem Metall, dann muss, wie eingangs erwähnt, ein geeigneter Bias-Kondensator zwischen den Hochfrequenz-Generator und der Kopplungselektrode geschaltet werden. Die Kapazität des Bias-Kondensators liegt elektrisch in Reihe mit der Kopplungskapazität und sollte kleiner als diese sein.

Anzustreben ist ein möglichst geringer Spalt zwischen der Kopplungselektrode und dem Substrat. Vorteilhaft ist es, die Spannung zwischen der Kopplungselektrode und der leitfähigen Schicht mittels einer entsprechenden Frequenz geringfügig unterhalb der Zündspannung einzustellen. Es entsteht so ein kapazitiver Vorwiderstand für die Plasmastrecke, der das Zünd- und Brennverhalten der Gasentladung günstig beeinflusst. Unerwünschte Entladungen zwischen der Kopplungselektrode und der Plasmakammer bzw. Einrichtungsbauteilen werden verhindert, indem Dunkelraum-Abschirmungen um die Kopplungselektrode angeordnet werden.

Die Wirksamkeit der Erfindung hängt sehr wesentlich von dem Abstand zwischen der Kopplungselektrode und der leitfähigen Schicht auf dem Substrat ab. Beispielsweise beträgt die erforderliche Frequenz etwa 5 kHz, wenn der Abstand, d.h. einschließlich der Dicke des isolierenden Substrates 1 mm beträgt. Größere Abstände bedingen proportional größere Frequenzen. Unabhängig davon bewirken höhere Frequenzen eine kleinere Spannung zwischen der Kopplungselektrode und der leitfähigen Schicht.

Vorteilhaft ist es, jeweils zwei Substrate oder zwei Gruppen von Substraten in erfinderischer Weise als jeweils eine Elektrode der Hochfrequenz-Entladung zu schalten bzw. auszubilden. Da dann die Spitzenwerte der Halbwellen der Hochfrequenz wirksam werden, kann die effektive Zündspannung des Plasmas wesentlich gesenkt werden. Die Zündspannung ist dann wesentlich höher als die Spannung zwischen den Einzelelektroden und der auf Masse liegenden Plasmakammer. Damit ist ein Überschlagen der Entladung zu den auf Masse liegenden Teilen der Plasmakammer praktisch ausgeschlossen.

Die Erfindung wird nachstehend an einem Ausführungsbeispiel näher erläutert werden.

Die Zeichnung zeigt schematisch eine Einrichtung zur plasmagestützten Beschichtung eines dünnwandigen Substrates aus einem isolierenden Material. In einer Vakuumkammer 1 sind auf nicht näher dargestellten Substrathalterungen Substrate 2 und 2' angeordnet. Die Substrate 2 und 2' sind beispielweise Kunststoff-Reflektoren für Leuchten.

Die isolierenden Substrate 2 und 2' sollen mit einer Reflexionsschicht aus Aluminium beschichtet werden, die abschließend mit einer Plasma-Polymerisationsschicht zu schützen ist.

Erfindungsgemäß soll das Plasma mittels Hochfrequenz-Entladung erzeugt werden. Dazu weist die Einrichtung einen Hochfrequenz-Generator 3 mit zwei Elektroden-Anschlüssen 5 und 5' auf. An die Elektroden-Anschlüsse 5 und 5' können wahlweise sowohl die Elektroden 6 und 6' als auch die Kopplungselektroden 7 und 7' angeschaltet werden. Die Kopplungselektroden 7 und 7' liegen wie Manschetten unmittelbar an der Rückseite der Substrate 2 und 2' an und überdecken etwa die Hälfte deren Rückseite und entsprechend der Oberflächen 4 und 4'.

Des weiteren weist die Einrichtung einen Vakuumverdampfer 8 sowie zwei Gaseinlässe 9 und 10 auf. Die Rückseiten der Elektroden 6 und 6' und der Kopplungselektroden 7 und 7' sind mit Dunkelraumabschirmungen 12, 12' und 12'' gegenüber der Vakuumkammer 1 abgeschirmt.

Nachfolgend wird die Einrichtung unter Anwendung des Verfahrens zur Anwendung bei der Herstellung einer Reflexionsschicht auf den Substraten 2 und 2' näher beschrieben.

Nach der Evakuierung der Vakuumkammer 1 wird durch den Gaseinlass 9 Argon bis zu einem Druck von 0,5 mbar eingelassen und eine Hochfrequenz-Entladung zwischen den Elektroden 6 und 6' gezündet. Es bildet sich ein Plasmagebiet 11 aus. Die Dunkelraumabschirmungen 12'' verhindern dabei, dass die Entladung zur Vakuumkammer 1 zündet.

Die Oberflächen 4 und 4' der Substrate 2 und 2' werden einem Plasma-Ätzprozess, der sogenannten Plasmareinigung, ausgesetzt. Auf die danach hochreine Oberflächen 4 und 4' wird aus der Vakuumverdampfer 8 Aluminium aufgedampft, wodurch sich auf den Oberflächen 4 und 4' eine dünne ca. 100 nm dicke leitfähige Aluminiumschicht ausbildet.

In der Folge werden die Kopplungselektroden 7 und 7' an die Elektroden-Anschlüsse 5 und 5' geschaltet. Dabei wird eine Frequenz vom 20 kHz am Hochfrequenz-Generator 3 eingestellt.

Die Dunkelraumabschirmungen 12 und 12' verhindern, dass die Entladung zur Vakuumkammer 1 zündet.

In Folge der erfindungsgemäßen Ausbildung bildet sich unter der Wirkung einer kapazitiven Kopplung zwischen den Kopplungselektroden 7 und 7' und der Aluminiumschicht eine Spannung aus und die Oberflächen 4 und 4' mit der Aluminiumschicht werden zu Elektroden der Hochfrequenz-Entladung.

Der weitere Verfahrensablauf kann nun spezifisch an die technologischen Erfordernisse angepasst werden. Unter der Einwirkung des Plasmas wird beispielsweise weiter Aluminium aus dem Vakuumverdampfer 8 verdampft bis eine auf den Substraten 2 und 2' eine Dicke der Aluminiumschicht von ca. 5 µm erreicht ist. Danach wird die Verdampfung des Aluminiums beendet.

Zur abschließenden Ausbildung einer plasmagestützt abgeschiedenen Polymer-Schutzschicht auf der als Reflexionsschicht wirkenden Aluminiumschicht wird über den Gaseinlass 10 Hexamethyldisiloxan (HMDS) in die Vakuumkammer 1 eingelassen und unter der Wirkung der als Elektroden der Hochfrequenz-Entladung wirkenden Aluminiumschicht eine dichte und damit harte und abriebfeste HMDS-Schutzschicht mit einer Dicke von ca. 1,5 µm abgeschieden.

Die Erfindung ist selbstverständlich nicht auf das beschriebene Ausführungsbeispiel beschränkt. So ist es ohne weiteres möglich, das Verfahren und die Einrichtung auch auf die Abscheidung einer Schutzschicht auf dekorativ metallisierte Kunststoff-Formteile mit ungleichmäßiger Dicke anzuwenden. Des weiteren kann die Erfindung zur Plasma-Oxidation oder -Nitrierung einer Metallschicht auf einem isolierenden Substrat wie für andere plasmagestützte Schichtabscheidungsverfahren, z.B. die Abscheidung einer TiN- oder TiCN-Schicht auf einer darunter befindlichen leitfähigen Schicht, eingesetzt werden.

Die Kopplungselektrode kann auch gleichzeitig als Halterung der Substrate genutzt werden.

## Patentansprüche

1. Verfahren zur Behandlung einer Oberfläche mindestens eines dünnwandigen Substrates aus einem isolierenden Material in einem Hochfrequenzplasma, bei dem auf der zu behandelnden Oberfläche eine dünne elektrisch leitfähige Schicht ausgebildet wird und die leitfähige Schicht als eine Elektrode der Hochfrequenz-Entladung geschaltet wird, wobei die Energiezufuhr zur leitfähigen Schicht mittels einer Kopplungselektrode erfolgt, welche an der Seite dicht am Substrat angeordnet wird, die sich gegenüber der leitfähigen Schicht befindet.

2. Verfahren nach Anspruch 1, **dadurch gekennzeichnet,** dass bei mehreren Substraten diese paarweise angeordnet werden und die zugehörigen Kopplungselektroden der beiden Substratgruppen mit entgegengesetzter Polarität symmetrisch an einen Hochfrequenz-Generator geschaltet werden.

3. Verfahren nach Anspruch 1 oder 2, **dadurch gekennzeichnet**, dass der Nullpunkt der Hochfrequenz und die Plasmakammer auf Massepotential gelegt werden.

4. Einrichtung zur Behandlung einer Oberfläche (4, 4') mindestens eines dünnwandigen Substrates (2, 2') aus einem isolierenden Material in einem Hochfrequenzplasma, mit einer Vakuumkammer (1), einer Halteeinrichtung für das Substrat (2, 2') und einem Hochfrequenz-Generators (3), wobei ein Elektroden-Anschluss (5, 5') des Hochfrequenz-Generators (3) mit einer Kopplungselektrode (7, 7') verbunden ist, welche an der Halteeinrichtung für das Substrat (2, 2') derart angeordnet ist, dass sie an der Seite dicht am Substrat (2, 2') anliegt, die sich gegenüber der zu behandelnden Oberfläche (4, 4') befindet.

5. Einrichtung nach Anspruch 4, **dadurch gekennzeichnet**, dass mehrere Halteeinrichtungen für Substrate (2, 2') vorhanden und in zwei elektrisch getrennten Gruppen angeordnet sind, deren zugehörige Kopplungselektroden (7, 7') mit den Elektroden-Anschlüssen (5,5') des Hochfrequenz-Generators (3) verbunden sind.

6. Einrichtung nach Anspruch 4 oder 5, **dadurch gekennzeichnet**, dass an der Kopplungselektrode (7, 7') eine Dunkelraumabschirmung (12) vorhanden ist, die die Kopplungselektrode (7, 7') gegenüber der Vakuumkammer (1) oder anderen Einbauteilen elektrisch abschirmt.

7. Einrichtung nach einem der Ansprüche 4 bis 6, **dadurch gekennzeichnet**, dass die Größe der Fläche der Kopplungselektrode (7, 7'), mit der diese an dem Substrat (2, 2') anliegt, kleiner als die Fläche der zu behandelnden Oberfläche (4, 4') des Substrates (2, 2') ist, aber mindestens 10% davon beträgt.

8. Anwendung der Einrichtung nach einem der Ansprüche 4 bis 7 zur Abscheidung einer Schicht auf einem Substrat (2, 2') unter Anwendung eines Verfahrens zur physikalischen Vakuum-Beschichtung.
